# EUROPEAN PATENT APPLICATION

(11) **EP 2 207 261 A1**
(43) Date of publication of application: **14.07.2010**
(21) Application number: 09173670.2
(22) Date of filing: 21.10.2009
(51) Int. Cl.: H03F 1/02, H03F 3/68, H03G 3/20, H04R 27/00, H04R 5/02, H04R 5/04, H04L 12/28, H04R 3/12

(54) **Audio device, AV system having the audio device, and method to control the audio device**

(30) Priority: 07.01.2009 KR 20090001234
(71) Applicant: Samsung Electronics Co., Ltd., Suwon-si, Gyeonggi-do 442-742 (KR)
(72) Inventor: Yoon, Jong Teak, Suwon-si, Gyeonggi-do (KR); Kim, Hag Do, Suwon-Si, Gyeonggi-do (KR)
(74) Representative: Van Someren, Petronella F. H. M.

(57) **Abstract**

An audio device, an Audio/Visual (A/V) system having the audio device, and a method to control the audio device, the audio device including a receiver connected to a transmitter of an external device to receive a signal from the external device, and a microcomputer to control power supply and audio output according to whether the signal is received.

## Description

### BACKGROUND

### 1. Field of the Invention

Embodiments of the present general inventive concept relate to an audio device to output an audio signal based on a signal received from an external device, an Audio/Visual (AV) system having the audio device, and a method to control the audio device.

### 2. Description of the Related Art

Generally, an audio device deals with sound waves in a sound range audible to the human ear and electrical signals converted from the sound waves. The audio device may be connected to a video device, thus forming an AV system. The AV system simultaneously outputs an audio signal and a video signal from an AV source. One example of an AV system is a home theater system. Rapid proliferation of large video devices and DVD players was a driving force behind the popularity of the home theater system through which a user may enjoy films at the level that may be expected from a movie theater.

The home theater system includes an AV source device such as a DVD player, a video device, and an audio device. The audio device includes an AV receiver and speakers, and may specifically include a subwoofer speaker, a center speaker, left and right front speakers, and left and right rear speakers. The video device may receive an external broadcast signal and display it. The audio device receives an audio signal from the video device or the AV source device and outputs the audio signal through the multi-channel speakers, which will be described below in detail.

In the home theater system, the video device and the AV source device each have a microcomputer to control the output of a power control signal and an audio signal. The microcomputer has separate ports to output the power control signal and the audio signal and the ports transmit the power control signal and the audio signal by different communication schemes. Also, the audio device has a microcomputer to control the output of a power control signal and an audio signal. The microcomputer has separate ports to receive the power control signal and the audio signal and the ports transmit and receive the power control signal and the audio signal by different communication schemes.

When the video device or the AV source device is turned on, referred to herein as being power-on, with its input and output ports connected, the microcomputer of the video device or the AV source device communicates with that of the audio device via the power control signal ports and, as a result, the audio device is switched to power-on. Upon the switch to the power-on state of the audio device with its audio signal port connected, the microcomputer of the video device or the AV source device communicates with that of the audio device and the audio device outputs an audio signal.

As described above, the use of separate power control signal ports and audio signal ports in the microcomputer of each device increases the manufacturing cost of the home theater system. Moreover, the installation space of the home theater system looks bad and has a low space efficiency due to multiple cables required to be connected to the ports.

### SUMMARY

Example embodiments of the present general inventive concept provide an audio device, AV system having the audio device, and a method of controlling the audio device with an improved appearance and/or space efficiency.

Additional features and utilities of the present general inventive concept will be set forth in part in the description which follows and, in part, will be obvious from the description, or may be learned by practice of the general inventive concept.

The foregoing and/or other features and utilities of the present general inventive concept may be achieved by providing an audio device including a receiver connected to a transmitter of an external device to receive a signal from the external device, and a microcomputer to control power supply and audio output according to whether the signal is received.

The receiver may include an optical port.

The signal may be an optical signal including a clock signal and an audio signal.

The audio device may further include a filter to cancel noise from the signal, a rectifier to rectify the noise-cancelled signal, and a switch to turn on, upon receipt of the rectified signal.

The microcomputer may control power supply and audio output in response to the switch being on.

The foregoing and/or other features and utilities of the present general inventive concept may also be achieved by providing an Audio/Visual (AV) system including an external device having a transmitter to output a signal, upon receipt of power, and an audio device having a receiver to receive the signal and a microcomputer to control power supply and audio output according to whether the signal is received.

Each of the transmitter of the external device and the receiver of the audio device may include an optical port and the transmitter may communicate with the receiver by optical communications.

The external device may be a video device and/or an AV source device.

The audio device may further include one or more speakers to output audio signals of one or more channels, and an AV receiver and/or an amplifier.

The audio device may further include a filter to cancel noise from the signal, a rectifier to rectify the noise-cancelled signal, and a switch to turn on upon receipt of the rectified signal.

The foregoing and/or other features and utilities of the present general inventive concept may also be achieved by providing a method of controlling an audio device, the method including determining whether a signal is received from an external device, and controlling power supply and audio output of the audio device according to whether the signal is received.

The signal may be received from the external device in response to power being applied to the external device.

The signal may be received by optical communications.

The signal may be an optical signal including a clock signal and an audio signal.

The method may further include canceling noise from the signal in response to the signal being received, rectifying the noise-cancelled signal, and turning on a switch based on the rectified signal.

The method may further include supplying power to the audio device and outputting an audio signal of the signal in response to the switch being on.

The foregoing and/or other features and utilities of the present general inventive concept may also be achieved by providing a device including a receiver to receive a signal from an external source, and a controller to control an on/off state and an output of the device according to the received signal.

The output of the device may include one or more audio signals.

The received signal may include an audio component.

The received signal may be an optical signal.

The receiver may include a connection port to connect to the external source.

The receiver may communicate with the external source through a wireless connection.

The controller may control the device to be turned on in response to receiving the signal.

The controller may control the device to be turned off in response to termination of the received signal.

The foregoing and/or other features and utilities of the present general inventive concept may also be achieved by providing a method of controlling a device, the method including controlling an on/off state and an output of the device according to a received signal.

The output of the device may include one or more audio signals.

The received signal may include an audio component.

The received signal may be an optical signal.

The method may further include receiving the received signal through a wired connection.

The method may further include receiving the received signal through a wireless connection.

The controlling the on/off state of the device may include turning the device on in response to receiving the received signal.

The controlling the on/off state of the device may include turning the device off in response to termination of the received signal.

### BRIEF DESCRIPTION OF THE DRAWINGS

These and/or other features and advantages of the present general inventive concept will become apparent and more readily appreciated from the following description of the embodiments, taken in conjunction with the accompanying drawings of which:
FIG. 1 is a block diagram illustrating an audio device according to an exemplary embodiment of the present general inventive concept;
FIG. 2 is a block diagram illustrating an audio device according to another exemplary embodiment of the present general inventive concept; and
FIG. 3 is a flowchart illustrating a control operation of the audio device of FIG. 2.

### DETAILED DESCRIPTION OF THE EMBODIMENTS

Reference will now be made in detail to various exemplary embodiments of the present general inventive concept, examples of which are illustrated in the accompanying drawings, wherein like reference numerals refer to like elements throughout. The embodiments are described below in order to explain the present general inventive concept by referring to the figures.

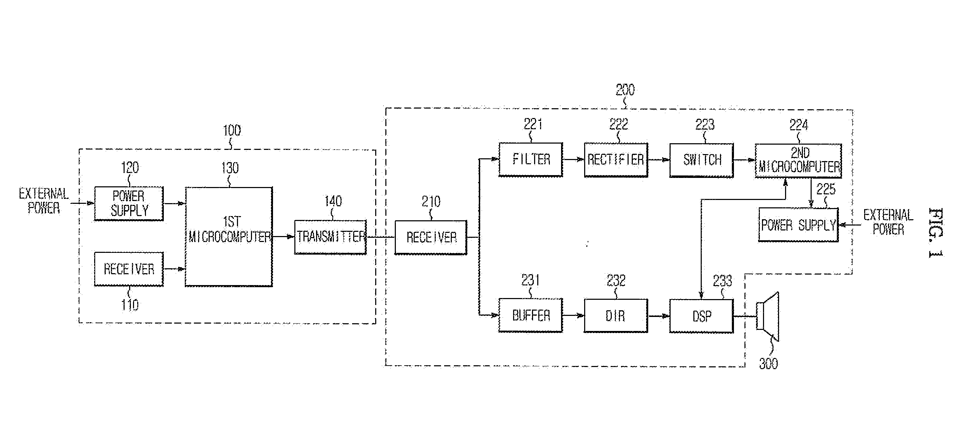

FIG. 1 is a block diagram illustrating an audio device according to an exemplary embodiment of the present general inventive concept. Referring to FIG. 1, the audio device may include an Audio/Visual (AV) receiver 200 and a speaker unit 300. While the audio device is illustrated in FIG. 1 to be the AV receiver 200, the present general inventive concept is not limited thereto. For example, the audio device may be an amplifier, equalizer, etc. The audio device may be connected to an external device 100 via a connection such as an optical port.

The external device 100 may be a video device that displays a video signal of an external broadcast signal. A Liquid Crystal Display (LCD), an Organic Light Emitting Diode (OLED), or the like may be used as the external device 100. Similarly, the external device 100 may be a device that provides the video signal to such a video device, such as a Digital Video Recorder (DVR), satellite signal receiver, cable box, etc.

The external device 100 may include a receiver 110, a power supply 120, a first microcomputer 130, and a transmitter 140. The descriptions of these various exemplary embodiments refer to respective controllers of these devices as microcomputers, but the present general inventive concept is not limited thereto.

The controller may be a relatively simple processor or other like unit that provides control over one or more other components of the respective devices.

The receiver 110 may receive a power-on signal or a power-off signal from a user to turn the external device 100 on or off, and may provide the received signal to the first microcomputer 130. The power supply 120 may receive power required to operate each component from an external power supply and may supply and/or block the operation power to or from each component according to the power-on signal or the power-off signal. Although the power-on and power-off signals are described as coming from a user in this embodiment, the present general inventive concept is not limited thereto. For example, the power-on and power-off signals may be received from another control device, or the first microcomputer may provide the power-on and power-off signals according to a timing circuit, and so on.

The first microcomputer 130 may transmit a power supply signal or a power blocking signal corresponding to the signal received from the receiver 110 to the power supply 120. Upon receipt of the power-on signal from the receiver 110, the first microcomputer 130 may transmit an output signal to the transmitter 140. The output signal may be an optical signal which may include one or more basic signals, such as, a clock signal, a multi-channel audio signal, and so on.

The transmitter 140 may transmit the optical signal to the AV receiver 200 of the audio device under the control of the first microcomputer 130. The transmitter 140 may include an optical port connected to an optical cable that, is connected to an optical port of a receiver 210 of the AV receiver 200. As the transmitter 140 of the external device 100 may be connected to the receiver 210 of the AV receiver 200 via the optical port and the optical cable, it may transmit the optical signal to the receiver 210 of the AV receiver 200. Alternatively, the receiver 210 of the AV receiver 200 may receive a signal, which may include an audio signal, through a wireless connection with the external device 100.

The external device 100 may further include a tuner to select a broadcast signal of a user-desired channel among received external broadcast signals, a demodulator to demodulate the selected broadcast signal, a demultiplexer to demultiplex the demodulated broadcast signal into video, audio, and additional information signals, and a video signal processor to process the video signal received from the demultiplexer so that the video signal may be displayed. As these various components of the external device 100 are well known in the art, a detailed explanation thereof has been omitted, and the components are likewise not illustrated in FIG. 1.

The AV receiver 200 of the audio device may decompress a compressed audio signal received from the external device 100, separate the decompressed audio signal according to channels, amplify the separated signals, and output the amplified signals through multi-channel speakers. The AV receiver 200 may include the receiver 210, a filter 221, a rectifier 222, a switch 223, a second microcomputer 224, a power supply 225, a buffer 231, a Digital Interface Receiver (DIR) 232, and a Digital Signal Processor (DSP) 233.

The receiver 210 may receive the optical signal from the transmitter 140 of the external device 100 and provide the optical signal to the filter 221 and the buffer 231. As previously described, the receiver 210 may include the optical port connected to the optical cable. That is, the receiver 210 may be connected to the transmitter 140 of the external device 100 via the optical port and the optical cable and receive the optical signal. The optical signal may include one or more basic signals, such as, a clock signal, a multi-channel audio signal, etc.

The filter 221 may cancel noise such as a surge from the optical signal, and the rectifier 222 may convert the voltage of the noise-cancelled signal to a positive voltage corresponding to the frequency of the noise-cancelled signal. Upon receipt of the rectified voltage, the switch 223 may turn on and provide a power-on signal to the second microcomputer 224. The switch 223 may be a switching device such as a transistor. As a base voltage of the transistor may increase upon receipt of the positive voltage, the transistor may turn on and the switch switches on. If the positive voltage is not applied to the transistor, the base voltage may drop and cause the transistor to turn off. Therefore, in response to the transistor turning off, the switch switches off.

Upon receipt of the on-signal from the switch 223, the second microcomputer 224 may control the power supply 225 to supply operation power to each component of the audio device. Upon receipt of an off-signal from the switch 223, the second microcomputer 224 may control the power supply 225 to block the operation power from being supplied to each component of the audio device. When such a coupled power control is triggered by the input of the on-signal from the switch 223, the second microcomputer 224 may control output of a digital audio signal received from the transmitter 140 of the external device 100.

The power supply 225 may be connected to an external power supply and may supply or block the operation power to or from each component under the control of the second microcomputer 224.

The buffer 231 may temporarily buffer the audio signal received from the external device 100 through the receiver 210. The DIR 232 may determine the sampling frequency of the buffered audio signal and interface a digital audio signal based on the sampling frequency between the buffer 231 and the DSP 233.

The DSP 233 may digitally process the digital audio signal received from the DIR 232. As a result, the DSP 233 may generate audio signals such as, for example, a center audio signal, a front audio signal, and a rear audio signal to be output through the speaker unit 300 so that the user may hear the audio signals.

The AV receiver 200 of the audio device may further include a Front Digital-to-Analog Converter (FDAC, not illustrated) to convert the front audio signal received from the DSP 233 to left and right front analog signals and output them to left and right front speakers of the speaker unit 300, and a Rear Digital-to-Analog Converter (RDAC, not shown) to convert the rear audio signal received from the DSP 233 to left and right rear analog signals and output them to left and right rear speakers of the speaker unit 300.

The AV receiver 200 may further include an Analog-to-Digital Converter (ADC, not illustrated) to convert an analog audio signal to a digital audio signal in a case in which an analog audio signal is received from the external device 100 through the receiver 210.

The speaker unit 300 of the audio device may include speakers that output audio signals of a plurality of channels. For example, in the case in which the speaker unit 300 includes a set of 5.1-channel speakers, the speaker unit 300 may include a center speaker disposed at a front center position of the user's listening area, front speakers disposed at both sides of the front of the listening area, rear speakers disposed at both sides behind the user, and a subwoofer speaker. The center speaker may output, for example, clean dialogues corresponding to a film being watched by the user. The center speaker may also output, for example, clean dialogues between the front speakers. The left and right front speakers may output, for example, musical scores, dialogues, a variety of sound effects, etc., thus giving a feeling of a natural and expansive stage set. The left and right rear speakers may enhance the natural and expansive feeling by outputting, for example, sound effects, surrounding sound, background sound, etc., in addition to the sound from the front speakers.

The subwoofer speaker may output lower frequency sound to thereby enhance a reality and liveliness of the output sounds in cooperation with the other speakers of the speaker unit 300.

As another example, the speaker unit 300 may have a set of 7.1-channel speakers that include left and right side speakers in addition to the 5.1-channel speakers previously described.

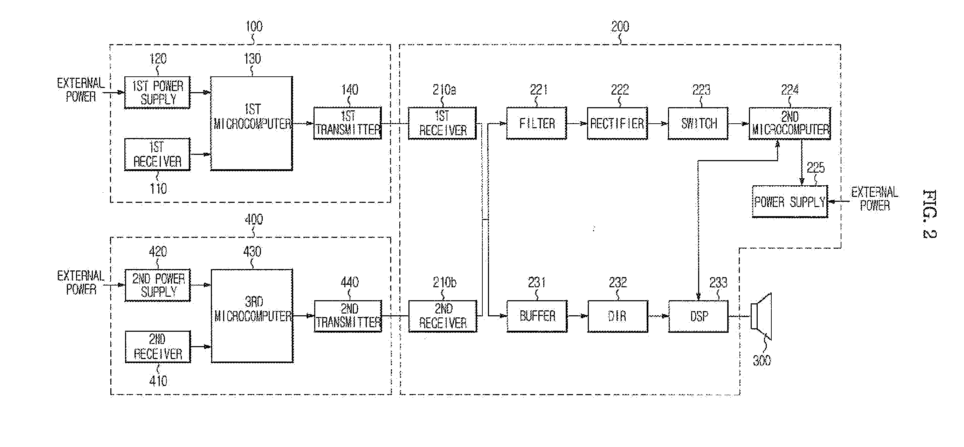

FIG. 2 is a block diagram illustrating an audio device according to another exemplary embodiment of the present general inventive concept. Referring to FIG. 2, the audio device may include the AV receiver 200 and the speaker unit 300. As discussed in regard to the audio device illustrated in FIG. 1, the audio device may also be an amplifier, equalizer, etc. The audio device may be connected to a plurality of external devices, such as first and second external devices 100 and 400 via connections, such as optical ports.

The first external device 100 illustrated in FIG. 2 is the same as the external device 100 illustrated in FIG. 1, and therefore the components are denoted by like reference numerals. However, since the second external device 400 has many of the same components as the first external device, the previously described receiver 110, power supply 120, and transmitter 140 are referred to in FIG. 2 and the corresponding descriptions as a first receiver 110, first power supply 120, and first transmitter 140.

Likewise, the AV receiver 200 illustrated in FIG. 2 includes substantially the same components as those illustrated in FIG. 1, and therefore these components are also denoted by like reference numerals. However, the receiver 210 illustrated in FIG. 1 has been replaced in FIG. 2 with a first receiver 210a and a second receiver 210b.

The first transmitter 140 of the first external device 100 may include an optical port connected to an optical cable. The first transmitter 140 may be connected to the first receiver 210a of the audio device via the optical port and the optical cable and may transmit the optical signal to the first receiver 210a.

The second external device 400 may be an AV source device such as a Personal Video Recorder (PVR), a DVD player, a DiVX-like multimedia player, a Set-Top Box (STB), etc., and may employ a medium that stores digital audio and video streams. However, the present general inventive concept is not limited thereto, as the second external device 400 may also be any of the devices previously discussed as possible examples of the first external device 100.

In a case in which the first external device 100 is a device which displays video content, the second external device 400 may transmit a compressed video signal to the first external device 100 and a compressed audio signal to the AV receiver 200.

The second external device 400 may include a second receiver 410, a second power supply 420, a third microcomputer 430, and a second transmitter 440. The second external device 400 may further includes a communication module (not illustrated) to transmit a video signal to the first external device 100.

The second receiver 410 may receive a power-on signal or a power-off signal from the user to turn the second external device 400 on/off, and may provide the received signal to the third microcomputer 430. The second power supply 420 may receive power required to operate each component from an external power supply and may supply or block the operation power to or from each component according to the power-on signal or the power-off signal.

The third microcomputer 430 may transmit a power supply signal or a power blocking signal corresponding to the signal received from the second receiver 410 to the second power supply 420. Upon receipt of the power-on signal from the second receiver 410, the third microcomputer 430 may transmit an output signal to the second transmitter 440. The output signal may be an optical signal, and may include one or more basic signals such as a clock signal, a multi-channel audio signal, etc.

Under control of the third microcomputer 430, the second transmitter 440 may transmit the optical signal to the AV receiver 200 of the audio device. The second transmitter 440 may include an optical port connected to an optical cable. The second transmitter 440 of the second external device 400 may be connected to the second receiver 210b of the audio device via the optical port and the optical cable and may therefore transmit the optical signal to the second receiver 210b.

The AV receiver 200 of the audio device may decompress a compressed audio signal received from the first or second external device 100 or 400, separate the decompressed audio signal according to channels, amplify the separated signals, and output the amplified signals through the speaker unit 300 that may include multi-channel speakers. The AV receiver 200 may include the first and second receivers 210a and 210b, the filter 221, the rectifier 222, the switch 223, the second microcomputer 224, the power supply 225, the buffer 231, the DIR 232, and the DSP 233.

The first receiver 210a may receive the optical signal from the first transmitter 140 of the first external device 100 and provide the optical signal to the filter 221 and the buffer 231. The first receiver 210a may include an optical port connected to an optical cable. That is, the first receiver 210a of the audio device may be connected to the first transmitter 140 of the first external device 100 via the optical port and the optical cable and receive the optical signal. The optical signal may include a basic signal, such as a clock signal, a multi-channel audio signal, etc.

The second receiver 210b may receive the optical signal from the second transmitter 440 of the second external device 400 and provide the optical signal to the filter 221 and the buffer 231. The second receiver 210b may include an optical port connected to an optical cable. That is, the second receiver 210b of the audio device may be connected to the second transmitter 440 of the second external device 400 via the optical port and the optical cable and may therefore receive the optical signal from the second external device 400. The optical signal may include a basic signal, such as a clock signal, a multi-channel audio signal, etc.

The filter 221 may cancel noise from the optical signal received from the first or second receiver 210a or 210b and the buffer 231 may temporarily buffer the optical signal received from the first or second receiver 210a or 210b.

The rectifier 222, the switch 223, the second microcomputer 224, the power supply 225, the DIR 232, and the DSP 233 may be identical to their counterparts illustrated in FIG. 1 and thus their description is not provided herein.

The AV receiver 200 may further include an FDAC (not illustrated) to convert a front audio signal received from the DSP 233 to left and right front analog signals and output them to left and right front speakers of the speaker unit 300, and an RDAC (not illustrated) to convert a rear audio signal received from the DSP 233 to left and right rear analog signals and output them to left and right rear speakers of the speaker unit 300. The AV receiver 200 may further include an ADC (not illustrated) to convert an analog audio signal to a digital audio signal in case in which an analog audio signal is received from the external device 100 through the receivers 210a or 210b.

The speaker unit 300 of the audio device may include speakers that output audio signals of a plurality of channels. As previously discussed, in the case in which the speaker unit 300 includes a set of 5.1-channel speakers, the speaker unit 300 may include a center speaker disposed at a front center position of the user's listening area (typically at the first external device 100), front speakers disposed at both sides of the front of the listening area, rear speakers disposed at both sides behind the user, and a subwoofer speaker. The center speaker may output, for example, clean dialogues corresponding to a film being watched by the user. The center speaker may also output, for example, clean dialogues between the front speakers. The left and right front speakers may output, for example, musical scores, dialogues, a variety of sound effects, etc., thus giving a feeling of a natural and expansive stage set. The left and right rear speakers may enhance the natural and expansive feeling by outputting, for example, sound effects, surrounding sound, background sound, etc., in addition to the sound from the front speakers.

The sub-woofer speaker may output lower frequency sound to thereby enhance a reality and liveliness of the output sounds in cooperation with the other speakers of the speaker unit 300.

As also previously discussed, the speaker unit 300 may have a set of 7.1-channel speakers that include left and right side speakers in addition to the 5.1-channel speakers described above.

In this manner, provisioning of a digital audio signal and sensing of power of an external device are simultaneously carried out through optical ports and power supply to an audio device is controlled in a coupled manner. Therefore, the convenience experienced by the user may be increased.

Since coupled power control may be performed by adding a filter, a rectifier, and a switch to an optical port of an audio device without using a separate port and microcomputer for the coupled power control, the manufacturing cost of the audio device may be decreased and the efficiency of the port installation space of the audio device may be increased.

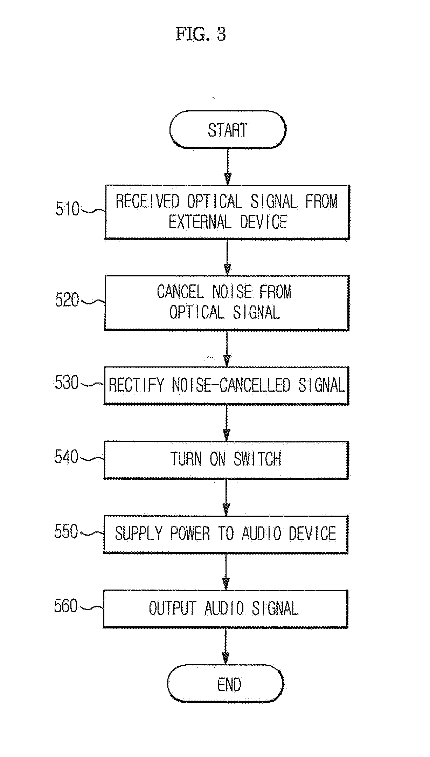

FIG. 3 is a flowchart illustrating a control operation of the audio device of FIG. 2. The control operation will be described with reference to FIG. 2.

As an example, upon receipt of power, the first external device 100 that may be a video device may display a video signal, such as a received external broadcast signal, on a screen, and may output an optical signal to the audio device. As another example of control operations of the audio device of FIG. 2, upon receipt of power, the second external device 400 that may be an AV source device such as a PVR, a DVD player, an STB, etc., may transmit a video signal read from a storage medium (not illustrated) to the first external device 100 and may output an optical signal to the audio device.

The first and second external devices 100 and 400 may be connected to the audio device via optical ports and optical cables. Hence, signals output from the first and second external devices 100 and 400 may be optical signals transmitted through the optical ports and the optical cables. Each of the optical signals may include a basic signal such as a clock signal, an audio signal, etc.

In operation 510 the audio device may receive the optical signal from the first or second external device 100 or 400.

Upon receipt of the optical signal from the first or second external device 100 or 400, the audio device may cancel noise from the optical signal in operation 520, rectify the noise-cancelled signal by converting its voltage to a positive voltage according to its frequency in operation 530, and turn on the switch 233 according to the rectified voltage in operation 540. The switch 223 may be a switching device such as a transistor. The application of the positive voltage may increase the base voltage of the transistor. As the transistor turns on as a result of the application of the positive voltage, the switch is turned on.

In response to the switch 223 being on, the AV receiver 200 of the audio device may supply operation power to each component of the audio device, thereby coupling power control with the external device in operation 550. In operation 560 the AV receiver 200 may output the digital audio signal received from the first or second external device 100 or 400.

In more detail, when power is supplied to each component of the audio device, the digital audio signal of the optical signal may be temporarily buffered in the buffer 231 and the buffered digital audio signal may be provided to the DSP 233 through the DIR 232. The digital audio signal may be digitally processed to be audible to the user, thus generating audio signals which may include a center audio signal, a front audio signal, and a rear audio signal. The front audio signal may be converted to left and right front analog signals and output to left and right front speakers. The rear audio signal may be converted to left and right rear analog signals and output to left and right rear speakers. The center audio signal may be converted to a center analog signal and output to a center speaker.

Upon being powered on, the audio device may continue monitoring reception of the optical signal from the first or second external device 100 or 400.

If the operation power is blocked from the first or second external device 100 or 400 and thus an optical signal is not received from the first or second external device 100 or 400, a positive voltage corresponding to the frequency of the optical signal is not generated. Consequently, the positive voltage is not applied to the base of the transistor and the base voltage of the transistor drops. As the transistor turns off, the switch 233 turns off.

In other words, the AV receiver 200 of the audio device may block the operation power from each component of the audio device, thus coupling power control with the external device.

The present general inventive concept can decrease the number of cables connecting the audio device and the external device, which allows the installation space of the audio device to look better and increases the efficiency of the installation space.

In addition, ports and cables connecting the audio device and the external device are decreased in number. Therefore, the manufacturing costs of the audio device and the external device are reduced.

Although various example embodiments of the present general inventive concept have been illustrated and described, it will be appreciated by those skilled in the art that changes may be made in these example embodiments without departing from the principles and spirit of the general inventive concept, the scope of which is defined in the appended claims and their equivalents.

## Claims

1. An audio device comprising:
a receiver connected to a transmitter of an external device, to receive a signal from the external device; and
a microcomputer to control power supply and audio output according to whether the signal is received.

2. The audio device according to claim 1, wherein the receiver includes an optical port.

3. The audio device according to claim 1, wherein the signal is an optical signal including a clock signal and an audio signal.

4. The audio device according to claim 1, further comprising a filter to cancel noise from the signal.

5. The audio device according to claim 4, further comprising a rectifier to rectify the noise-cancelled signal.

6. The audio device according to claim 5, further comprising a switch to turn on, upon receipt of the rectified signal.

7. The audio device according to claim 6, wherein when the switch is on, the microcomputer controls power supply and audio output.

8. An Audio/Visual (AV) system comprising:
an external device having a transmitter to output a signal, upon receipt of power; and
an audio device having a receiver to receive the signal and a microcomputer to control power supply and audio output according to whether the signal is received.

9. The AV system according to claim 8, wherein each of the transmitter of the external device and the receiver of the audio device includes an optical port and the transmitter communicates with the receiver by optical communications.

10. The AV system according to claim 8, wherein the external device is at least one of a video device and an AV source device.

11. The AV system according to claim 8, wherein the audio device further includes a speaker of a plurality of channels and one of an AV receiver and an amplifier.

12. A method to control an audio device, comprising:
determining whether a signal is received from an external device; and
controlling power supply and audio output of the audio device according to whether the signal is received.

13. The method according to claim 12, wherein when power is applied to the external device, the signal is received from the external device.

14. The method according to claim 13, wherein the signal is received by optical communications.

15. The method according to claim 12, further comprising:
canceling noise from the signal, when the signal is received;
rectifying the noise-cancelled signal; and
turning on a switch based on the rectified signal
supplying power to the audio device and outputting an audio signal of the signal, when the switch is on.
